Europäisches Patentamt

European Patent Office

Office européen des brevets

(11) Veröffentlichungsnummer: **0 293 728**
**A2**

## (12) EUROPÄISCHE PATENTANMELDUNG

(21) Anmeldenummer: **88108304.2**

(22) Anmeldetag: **25.05.88**

(51) Int. Cl.⁴: **H04L 1/24**

(30) Priorität: **03.06.87 DE 3718632**

(43) Veröffentlichungstag der Anmeldung:
**07.12.88 Patentblatt 88/49**

(84) Benannte Vertragsstaaten:
**FR GB NL**

(71) Anmelder: **Deutsche Forschungs- und Versuchsanstalt für Luft- und Raumfahrt e.V.**
**Linder Höhe Postfach 90 60 58**
**D-5000 Köln 90(DE)**

(72) Erfinder: **Schweikert, Robert, Dr., Dipl.-Phys.**
**Am Riedfeld**
**D-8031 Seefeld(DE)**
Erfinder: **Förster, Hans Peter, Dipl.-Ing.**
**Bahnhofstrasse 4**
**D-8031 Wessling(DE)**
Erfinder: **Vinck, Adrianus, Prof.**
**Warande 16**
**NL-5641 PJ Eindhoven(NL)**

(74) Vertreter: **von Kirschbaum, Albrecht,**
**Dipl.-Ing.**
**Hermann-Ehlers-Strasse 21a**
**D-8034 Germering(DE)**

(54) Verfahren zur Dekodierung von Daten.

(57) Bei einem Kodier-/Dekodierverfahren, bei welchen Kodewörter mit einer Länge von n Bits übertragen werden, wird sendeseitig in einem Kodierer Daten mit (n-1) Nutzbits ein Paritätsbit hinzugefügt. Empfangsseitig wird dann für jedes Paritätsbit nach einem Anpassungsfilter eine Abtastung durchgeführt; anschließend wird ein wertkontinuierlicher Wert (d.h. eine Entscheidungsvariable) mit einem Schwellenwert verglichen, woraus dann ein Entscheidungswert gebildet wird. Im Falle einer Paritätsverletzung wird dann dasjenige Bit invertiert, dessen Entscheidungswert den geringsten Abstand von der Entscheidungsschwelle hat.

Vorzugsweise werden die Daten sendeseitig vor einer Kodierung gespreizt und empfangsseitig nach der Dekodierung entspreizt, so daß zur Vermeidung von Mehrfachfehlern in einem Kodewort aufeinanderfolgende Bits in verschiedenen Kodewörtern übertragen werden.

## Verfahren zur Dekodierung von Daten

Die Erfindung betrifft ein Verfahren zur Dekodierung von Daten nach dem Oberbegriff des Anspruchs 1.

Bei digitaler Datenübertragung werden durch Störungen auf der Übertragungsstrecke und durch Eigenrauschen in den Empfangseinrichtungen die zu übertragenden binären Informationseinheiten, d.h. die Bits, an der Empfangseinrichtung verfälscht. Die Rate, mit der solche fehlerhaften Bits auftreten, die daher auch als Bitfehlerrate (BER) bezeichnet wird, hängt von dem Übertragungsverfahren und den Kanalstörungen ab und ist eine Funktion des Signal-Rauschabstandes.

Bei Kommunikationssystemen, bei welchen vor allem - wie in der Satellitenkommunikation - die Leistungsbegrenzung von entscheidender Bedeutung ist, sind zur Fehlerkorrektur in vorteilhafter Weise Kanalkodierungsverfahren anwendbar. Mit Hilfe dieser Verfahren kann bei einem vorgegebenen Signal-Rauschabstand die Bitfehlerrate verbessert werden - oder, was gleichbedeutend ist, - für eine bestimmte Bitfehlerrate kann der erforderliche Signal-Rauschabstand reduziert werden.

Kodier-/Dekodierverfahren, bei welchen entweder eine sogenannte harte Entscheidung (hard decision) oder eine sogenannte weiche Entscheidung (soft decision) angewendet wird, sind bekannt. Nachteilig bei diesen bekannten Verfahren ist die Komplexität bei der Dekodierung der Daten. Insbesondere für hohe Datenraten von beispielsweise 140 Mbit/s, lassen sich solche komplexen Verfahren technisch nicht oder falls überhaupt, nur außerordentlich schwer realisieren. So ist auch in F.J. Furler "Fehlerkorrigierende Block-Codierung für die Datenübertragung" Birkhäuser Verlag 1981, Seiten 218 bis 229, im Zusammenhang mit der "weichen Docodierung" nur von der geometrischen Distanz die Rede.

Ziel der Erfindung ist es daher, zur Verbesserung der digitalen Übertragung bzw. der Bitfehlerrate bei Auftreten von Einzel-, aber auch von Doppel- bzw. Mehrfachfehlern ein einfach ausführbares Kodier-/Dekodierverfahren zu schaffen, das auch bei hohen Datenraten angewendet werden kann. Ein weiteres Ziel der Erfindung besteht darin, ein einfach ausführbars Dekodierverfahren zu schaffen, welches zur Fehlerkorrektur gegebenenfalls auch in Verbindung mit einer gleichzeitigen Auflösung von Phasenmehrdeutigkeit, einer Unterstützung der Synchronisation oder einer Indikation der Kanal-Bitfehlerrate verwendbar und einsatzbar ist. Gemäß der Erfindung ist dies bei einem Verfahren zur Dekodierung von Daten nach dem Oberbegriff des Anspruchs 1 durch die Merkmale im kennzeichnenden Teil des Anspruchs 1 erreicht. Vorteilhafte Weiterbildungen der Erfindung sind Gegenstand der Unteransprüche.

Gemäß einer bevorzugten Ausführungsform werden bei dem erfindungsgemäßen Verfahren Kodewörter, d.h. eine Nachricht m mit einer Länge von n Bits übertragen, wobei sendeseitig in einem Kodierer (n-1) Nutzbits ein Paritätsbit p hinzugefügt wird. Dieses Paritätsbit p ist in Abhängigkeit von der Anzahl der logischen Nullen bzw. Einsen der (n-1) Nutzbits eine logische Null oder eine logische Eins; hierbei ist die Anzahl der Einsen innerhalb eines n Bit langen Kodeworts $\underline{x}$ = (m,p) immer gerade oder ungerade. Empfangsseitig wird zunächst für jedes Paritätsbit p der analoge, wertkontinuierliche Wert, d.h. eine Entscheidungsvariable, mit einem Schwellenwert, d.h. einer Entscheidungsschwelle verglichen und es wird eine direkte binäre Entscheidung getroffen, d.h. die eingangs erwähnte harte Entscheidung (hard decision) durchgeführt. In einem nachgeschalteten Dekodierer erfolgt dann empfangsseitig die Überprüfung der Parität jedes Kodewortes. Bei einer korrekten Parität werden die (n-1) Nutzbits unverändert ausgegeben. Bei einer nicht korrekten Parität wird jedoch das Bit in dem jeweiligen Kodewort invertiert, dessen korrespondierender Entscheidungswert den geringsten Abstand von der Entscheidungsschwelle aufweist; es wird also die sogenannte weiche Entscheidung (soft decision) durchgeführt. Hierbei handelt es sich um eine "Minimum-Distance" Dekodierung. Mit dem erfindungsgemäßen Verfahren läßt sich somit ein (1) Fehler pro Kodewort korrigieren.

Das erfindungsgemäße Verfahren läßt sich auf verschiedene Arten in vorteilhafter Weise ausgestalten. Beispielsweise treten bei differnzkohärenter, digitaler Phasenmodulation (DPSK) vor allem Doppelbitfehler auf, welche nicht korrigiert werden können. Um dennoch das erfingungsgemäße Kodier-/ Dekodierschema anwenden zu können, wird in derartigen Fällen das erfindungsgemäße Verfahren in Verbindung mit einer einfachen Datenspreizung, dem sogenannten Interleaving, angewendet. Hierunter ist zu verstehen, daß zunächst das erste (1.) Bit (oder Symbol) eines Kodewortes 1, dann das erste (1.) Bit (oder Symbol) eines Kodewortes 2 bis zum ersten (1.) Bit (oder Symbol) eines Kodewortes m übertragen wird, bevor das zweite (2.) Bit (oder Symbol) des Kodewortes 1 ... usw. übertragen wird. Empfangsseitig sind die Bits der m Kodeworte zwischenzuspeichern. Hierbei ist zu beachten, daß bei dem erfindungsgemäßen Dekodierverfahren für eine weiche Entscheidung (soft decision) pro Kodewort nur ein analoger Wert zusätzlich gespeichert werden muß.

Bei Übertragungssystemen, bei welchen eine Phasenmehrdeutigkeit auftritt, wie beispielsweise bei der digitalen Phasenmodulation, wird mit Hilfe des erfindungsgemäßen Kodier-/Dekodierschemas zur Auflösung von Fehlern durch Mehrdeutigkeit in folgender Weise vorgegangen:

Bei einer geraden Anzahl von n Bits wird das erfindungsgemäße Verfahren in Verbindung mit einer Differenzkodierung (differential encoding) angewandt. Die (-1) Nutzbits werden differenzkodiert und das n-te Eingangsbit des Differenz-Kodierers wird so gewählt, daß der Ausgang der Parität den vorangegangenen (n-1) Bits entspricht. Die Phasenmehrdeutigkeit verändert die Parität der Kodeworte nicht. Im Anschluß an die mit dem erfindungsgemäßen Verfahren durchgeführte Dekodierung erfolgt dann in bedannter Weise die Differenz-Dekodierung.

Bei einer ungeraden Anzahl von n Bits wird aufgrund einer Phasenmehrdeutigkeit die Parität systematisch inkorrekt. Hierbei wird dann so verfahren, daß in aufeinanderfolgenden Zeitintervallen von T Kodeworten die Anzahl der Paritätsfehler überprüft wird. Unterschreitet hierbei diese Anzahl eine Schwelle von $L \leq T$, dann werden die Bits der letzten T Kodeworte und alle nachfolgenden Bits invertiert.

Eine Unterstützung einer Wort-Synchronisation mittels des erfindungsgemäßen Verfahrens geschieht in folgender Weise:

Im synchronisierten Zustand ist die von dem Signal-Rauschabstand abhängige Paritätsfehlerrate normalerweise sehr klein. Dagegen beträgt im unsynchronisierten Zustand die Wahrscheinlichkeit für einen Paritätsfehler bei gleichwahrscheinlich auftretenden Datenbits 1/2. Es wird daher so verfahren, daß mit einer Verzögerung von T Kodeworten dekodiert wird. Überschreitet in den Zeitintervall T die Anzahl L der Paritätsfehler $L \cong T/2$ dann wird durch eine Bitverschiebung der Synchronisationsmode gesucht, welcher zu der geringsten Paritätsfehlerrate führt. Zur Beschleunigung des Suchvorgangs können dann gegebenenfalls n parallele Dekodierer verwendet werden.

Zur einer Indikation der Kanal-Bitfehlerrate bzw. des Signal-Rauschabstandes wird in folgender Weise vorgegangen:

Zuerst wird die Paritätsfehlerrate ermittelt. Da es einen eindeutigen Zusammenhang zwischen dieser Paritätsfehlerrate und der Bitfehlerrate und somit dem Rausch-Signalabstand gibt, können beide Größen direkt bestimmt werden.

Auch zu einer Rahmen- bzw. Wort-Synchronisation kann das erfindungsgemäße, einfach durchzuführende Kodier-/Dekodierschema in vorteilhafter Weise folgendermaßen angewendet werden:

Es werden zwei Kodeworte $\underline{x}$ und $\underline{x}'$ mit einer Länge von n Bits abwechselnd hintereinander übertragen, beispielsweise als Präambel. Das Kodewort $\underline{x}$ wird durch $x = (0, m, p)$ und das Kodeworte $\underline{x}'$ wird durch $\underline{x}' = (1, m, \bar{p})$ wiedergegeben, wobei mit m die Länge einer Nachricht, mit p das Paritätsbit und mit $\bar{p}$ das invertierte Paritätsbit bezeichnet sind; eine (n-2) Nutzbits lange Nachricht m kann hierbei beliebig, jedoch dann fest gewählt sein.

Für eine gerade Anzahl n Bits führt das erfindungsgemäße Dekodierverfahren im synchronisierten Mode, d.h. im störungsfreien Fall, zu keinem Paritätsfehler; allerdings kommt es in allen (n-1) unsynchronisierten Zuständen jeweils zu einer Paritätsverletzung pro Kodewort. Dies gilt ebenso, falls alle Bits invertiert sind, d.h. eine Phasenmehrdeutigkeit vorliegt. Die Wortsynchronisation wird dann solange verändert, bis ein Zustand erreicht ist, indem die relative Häufigkeit der Paritätsverletzungen am geringsten ist.

Bei einer Anzahl von n Bits tritt für den Fall eines nicht invertierten Bitstromes am Eingang eines Dekodierers, wenn keine Kanalstörungen vorliegen, im synchronisierten Zustand kein Paritätsfehler auf. Dagegen tritt in allen (n-1) möglichen, unsynchronisierten Zuständen jeweils ein Paritätfehler pro Kodewort auf. Sind dagegen alle Bits invertiert, erscheint nur bei einem synchronisierten dekodierer eine Paritätsverletzung pro Kodewort, während in allen anderen Synchronisationszuständen kein Paritätsfehler vorkommt.

Die relative Häufigkeit von Paritätsverletzungen wird für alle n möglichen Synchronisationszustände gezählt. Überschreitet für (n-1) Zustände die Anzahl dieser Fehler eine Schwelle, wird der Zustand mit der geringsten Anzahl von Paritätsfehlern als "in Synchronisation" angenommen. Unterschreitet allerdings die Anzahl der Fehler für (n-1) Zustände eine weitere Schwelle, so wird der Zustand mit der größten Anzahl von Fehlern als "in Synchronisation" angesehen, und alle weiteren Bits werden invertiert. Durch dieses Verfahren ist dann nicht nur eine Wortsynchronisation, sondern auch die Auflösung der Phasenmehrdeutigkeit erreicht.

Nachfolgend wird anhand von Ausführungsbeispielen unter Bezugnahme auf die anliegenden Zeichnungen das erfindungsgemäße Verfahren weiter erläutert. Es zeigen:

Fig.1 eine Kurvendarstellung, in welcher auf der Ordinate die Bitfehlerrate als Funktion des auf der Abszisse aufgetragenen Verhältnisses der Energie $E_b$ pro Informationsbit zur einseitigen Rauschleistungsdichte $N_0$ aufgetragen ist, und

Fig. 2 eine weitere Kurvendarstellung, in welcher auf der Ordinate ebenfalls wieder die Bitfehlerrate als Funktion des auf der Abszisse aufgetragenen Verhältnisses der Energie $E_b$ pro Informationsbit zur einseitigen Rauschleistungsdichte $N_0$ aufgetragen ist.

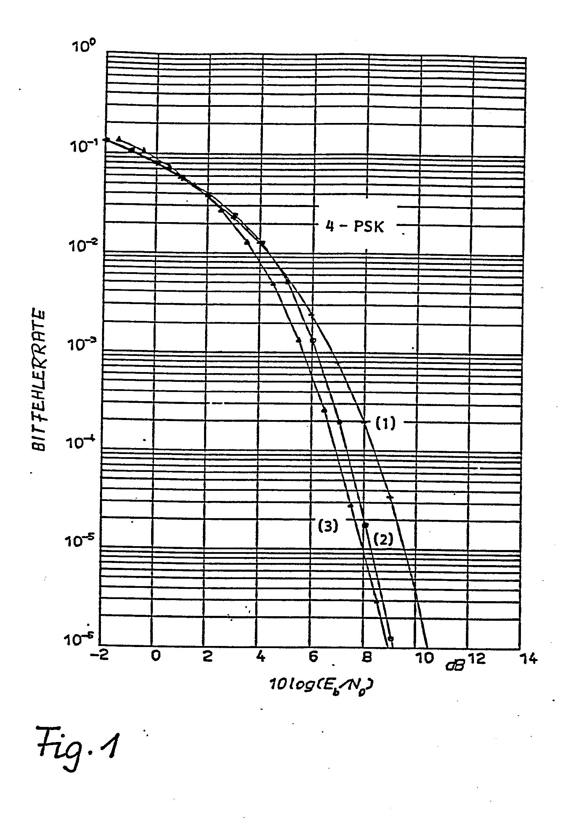

Hierbei ist in Fig.1 die Bitfehlerrate (BER) als Funktion des Verhältnisses der Energie $E_b$ pro Informationsbit zu der einseitigen Rauschleistungsdichte $N_0$ für den Fall einer digitalen Übertragung in einem Kanal mit additivem, weißem Gaußschen Rauschen (AWGN) bei Anwendung von (binärer bzw.) quartenärer PSK-Modulation aufgetragen. Hierbei gibt eine Kurve (1) das Ergebnis bei einer direkten, binären unkodier ten Entscheidung wieder, während Kurven (2) und (3) das Resultat bei der Verwendung des erfindungsgemäßen Kodier-/Dekodierverfahrens mit n = 64 bzw. n = 9 in Form von Simulationsergebnissen darstellen.

Das erfindungsgemäße Verfahren läßt sich jedoch auch für die Übertragung in einem Kanal anwenden, bei welchem zusätzlich zu dem additiven, weißen Gaußschen Rauschen (AWGN) der Empfangspegel schwankt, d.h. es läßt sich in einem Fading-Kanal anwenden. Durch eine Spreizung können Mehrfachbitfehler, die aufgrund der langsam variierenden Pegelschwankungen auftreten, in einzelne Bitfehler aufgelöst werden. Nach einer Entspreizung kann dann eine Dekodierung durchgeführt werden, wobei, wie beispielsweise von J.Hagenauer in AEÜ 34, Seiten 220 bis 237 (1980) unter dem Tital "Zur Kanalkapazität bei Nachrichtenkanälen mit Fading und gebündelten Fehlern" vorgeschlagen worden ist, eine Kanal-Zustandsinformation, beispielsweise durch eine Pegelmessung eines automatischen Schwundausgleichs (AGC) mitbenutzt werden. Bei einer Mitbenutzung der Kanal-Zustandsinformation ist dann nur die Entscheidungsregel, welches Bit innerhalb eines Kodewortes zu invertieren ist, leicht zu modifizieren. Aufgrund der Verwendung des erfindungsgemäßen Verfahrens muß auch in diesem Fall nur ein analoger Wert pro Kodewort zusätzlich gespeichert werden.

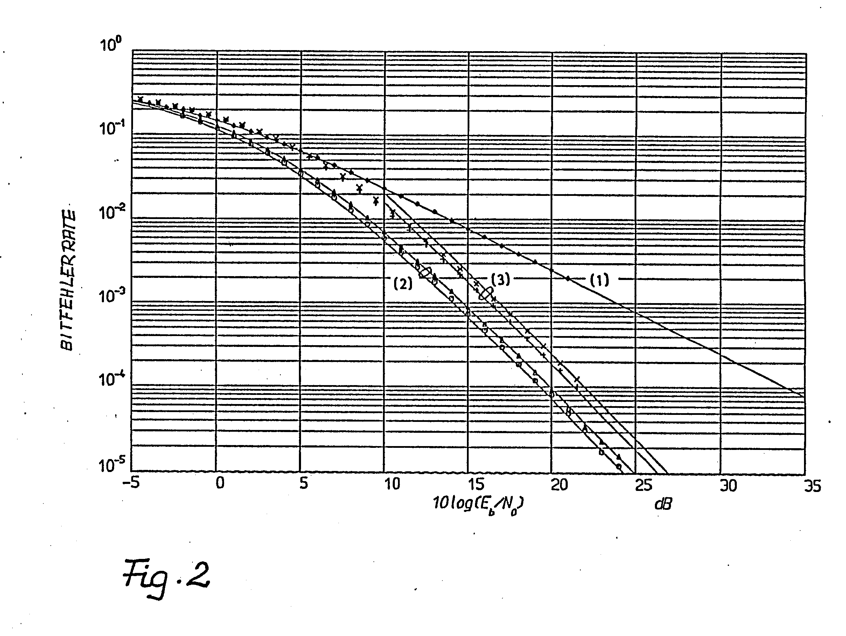

In Fig.2 ist das Resultat für einen (relativ zur Datenrate) langsam variierenden Rayleighfading-Kanal (einen Mobilfunkkanal) mit hinreichend großer Spreizung und einer kohärenten PSK-Modulation dargestellt. Die eingetragenen Meßpunkte geben die durch Rechnersimulationen erzielten Bitfehlerraten als Funktion des Verhältnisses der Energie $E_b$ pro Informationsbit zu der Rauschleistungsdichte (dem Signal-Rauschabstand) an. Hierbei zeigt eine Kurve (1') die Bitfehlerrate für eine direkte, binäre, unkodierte Entscheidung an, während Kurven (2'), die Bitfehlerrate bei Verwendung des erfindungsgemäßen Kodier-/Dekodierverfahrens mit n = 2 ohne eine bzw. mit einer Verwendung von Kanal-Zustands-information und Kurven (3') die Bitfehlerrate mit n = 9 ohne bzw. mit einer Verwendung von Kanal-Zustandsinformation wiedergeben.

Aus Fig.2 ist deutlich erkennbar, daß trotz der Verwendung von Kanal-Zustandsinformation die Bitfehlerrate nur geringfügig verbessert wird. Bei einer Anwendung des erfindungsgemäßen Kodier-/Dekodierverfahrens kann daher auf die Verwendung der Kanal-Zustandsinformation verzichtet werden.

## Ansprüche

1. Verfahren zur Dekodierung von Daten, wobei Kodewörter mit einer Länge von n Bits übertragen werden, indem sendeseitig in einem Kodierer (n-1) Nutzbits ein Paritätsbit hinzugefügt wird, dadurch **gekennzeichnet,**

daß empfangsseitig für jedes Paritätsbit nach einem Anpassungsfilter eine Abtastung durchgeführt wird, ein wertkontinuierlicher Wert (eine Entscheidungsvariable) mit einem Schwellenwert verglichen wird und daraus ein Entscheidungswert gebildet wird und

daß im Falle einer Paritätsverletzung zur Bestimmung des wahrscheinlichsten Kodeworts nur dasjenige Bit invertiert wird, dessen Entscheidungswert den geringsten Abstand von der Entscheidungsschwelle hat.

2. Verfahren nach Anspruch 1, dadurch **gekennzeichnet,** daß die Daten sendeseitig vor einer Kodierung gespreizt und empfangsseitig nach der Dekodierung entspeizt werden, dergestalt, daß zur Vermeidung von Mehrfachfehlern in einem Kodewort aufeinanderfolgende Bits in verschiedenen Kodewörtern übertragen werden.

3. Verfahren nach Anspruch 1, für eine Übertragung von Daten mittels einer Zwei- oder einer Vierphasenmodulation mit kohärenter Demodulation, dadurch **gekennzeichnet,** daß bei einer geraden Anzahl von n Bits die Daten sendesei tig vor der Kodierung und empfangsseitig nach der Dekodierung jeweils differenzkodiert werden.

4. Verfahren nach Anspruch 1, für eine Übertragung von Daten mittels einer Zwei- oder einer Vierphasenmodulation mit kohärenter Demodulation, dadurch **gekennzeichnet,** daß bei einer ungeraden Anzahl von n Bits empfangsseitig die relative Häufigkeit der Paritätsverletzung gezählt wird, und daß bei Überschreiten einer festen Schwelle die empfangenen Bits invertiert werden.

5. Verfahren nach einem der Ansprüche 1 bis 4, dadurch **gekennzeichnet,** daß empfangsseitig die relative Häufigkeit der Paritätsverletzungen gezählt wird, und daß eine Wortsynchronisation solange verändert wird, bis eine feste Schwelle unterschritten wird.

6. Verfahren nach einem der Ansprüche 1 bis 4, dadurch **gekennzeichnet,** daß empfangsseitig die relative Häufigkeit der Paritätsverletzungen gezählt wird, und daß aus diesem Wert eine Fehlerbitrate bzw. der Signal-Rauschabstand ermittelt wird.

7. Verfahren nach Anspruch 1 für eine Wortsynchronisation, dadurch **gekennzeichnet**, daß sendeseitig eine alternierende Sequenz von zwei Kodeworten als Präambel gesendet wird, daß empfangsseitig die relative Häufigkeit der Paritätsverletzungen gezählt wird, und daß die Wortsynchronisation solange verändert wird, bis eine feste Schwelle unterschritten wird, wenn die Anzahl von n Bits gerade ist, oder die relativen Häufigkeiten der Paritätsverletzungen für alle n Synchronisationszustände gezählt und hieraus die Information "in Synchronisation" und die Information bezüglich der Mehrphasendeutigkeit bestimmt wird, wenn die Anzahl von n Bits ungerade ist.

Fig. 1

Fig. 2